(19) Europäisches Patentamt

European Patent Office

Office européen des brevets

(11) **EP 1 686 688 A1**

(12) **EUROPEAN PATENT APPLICATION**
published in accordance with Art. 158(3) EPC

(43) Date of publication:
02.08.2006 Bulletin 2006/31

(51) Int Cl.:
*H03H 9/17* (2006.01)     *H03H 9/05* (2006.01)
*H03H 3/02* (2006.01)     *G10K 11/04* (2006.01)
*H01L 41/08* (2006.01)     *H01L 41/22* (2006.01)

(21) Application number: 04818912.0

(22) Date of filing: 17.11.2004

(86) International application number:
PCT/JP2004/017054

(87) International publication number:
WO 2005/050838 (02.06.2005 Gazette 2005/22)

(84) Designated Contracting States:
AT BE BG CH CY CZ DE DK EE ES FI FR GB GR
HU IE IS IT LI LU MC NL PL PT RO SE SI SK TR

(30) Priority: 20.11.2003 JP 2003391388

(71) Applicant: MURATA MANUFACTURING CO., LTD.
Nagaokakyo-shi, Kyoto 617-8555 (JP)

(72) Inventors:
• YAMADA, Yuya,
MURATA MANUFACTURING CO., LTD.
Nagaokakyo-shi,
Kyoto 617-8555 (JP)

• KAWAKAMI, Akihiko,
MURATA MANUFACTURING CO., LTD.
Nagaokakyo-shi,
Kyoto 617-8555 (JP)
• MATSUSHITA, Koji,
MURATA MANUFACTURING CO., LTD.
Nagaokakyo-shi,
Kyoto 617-8555 (JP)
• UCHIDA, Shinsuke,
MURATA MANUFACTURING CO., LTD.
Nagaokakyo-shi,
Kyoto 617-8555 (JP)

(74) Representative: Zinnecker, Armin et al
Lorenz-Seidler-Gossel,
Widenmayerstrasse 23
80538 München (DE)

(54) **COMPOSITE MATERIAL VIBRATION DEVICE**

(57)     A composite material vibrator that has a relatively simple structure, that can be supported without hardly affecting the vibration characteristics of a vibrating component, and that can be easily reduced in size is provided.

A composite material vibrator includes a vibrating component that is composed of a material having a first acoustic impedance $Z_1$ and that serves as a vibration source; a reflective layer that is composed of a cured product of a resin composition containing at least a curable resin curable by heat, a curing agent, and a silicone compound, the cured product having a second acoustic impedance $Z_2$ lower than the first acoustic impedance $Z_1$ and that is connected to the vibrating component; and a holding component that is composed of a material having a third acoustic impedance $Z_3$ higher than the second acoustic impedance $Z_2$ and that is connected to surface of the reflective layer, the surface being opposite to the surface connected to the vibrating component, wherein vibration propagated from the vibrating component to the reflective layer is reflected at the interface between the reflective layer and the holding component.

FIG. 1

**Description**

Technical Field

The present invention relates to a composite material vibrator in which a plurality of parts composed of materials having different acoustic impedances are combined, for example, to a composite material vibrator in which reflective layers having a low sound velocity and a low damping are connected to a vibrating component such as a piezoelectric element.

Background Art

As piezoelectric resonating components constituting a piezoelectric resonator, a piezoelectric filter, or the like, a component prepared by laminating case substrates on and under a piezoelectric vibrating element has been widely used. In such a case, a space for not interfering with the vibration of the piezoelectric vibrating part of the piezoelectric element must be formed in the laminate. For this purpose, the following methods have been employed. In a method, a recess for forming a cavity is formed on a surface of a case substrate to be laminated, the surface being adjacent to the piezoelectric element. In another method, in laminating the case substrates on the piezoelectric element, in order to form a cavity, an area on which an adhesive is applied is formed on an area except for the cavity.

As described above, in the known laminated piezoelectric resonating components, a cavity for not interfering with the vibration of the piezoelectric vibrating part must be formed. Therefore, is has been difficult to reduce the size of the component and to reduce the cost.

On the other hand, a laminated structured bulk acoustic wave filter that does not include a cavity is disclosed (see Patent Document 1). As shown in Fig. 3, in a bulk acoustic wave filter 211, a plurality of films are laminated on a substrate 212 to form a piezoelectric filter.

Namely, in this laminated structure, a piezoelectric layer 213 is provided, and electrodes 214 and 215 are laminated on the upper surface and the lower surface of the piezoelectric layer 213, respectively, to form a piezoelectric resonator.

An acoustic mirror 219 is provided on the lower surface of the piezoelectric resonator. The acoustic mirror 219 has a laminated structure including an upper layer 216, an interlayer 217, and a lower layer 218, the structure being formed by laminating films composed of silicon, polysilicon, or the like. Another acoustic mirror 220 having a similar laminated structure is laminated on the upper surface of the piezoelectric resonator. A passivation film 221 functioning as a protective film is provided on the acoustic mirror 220.

In the acoustic mirror 219, the impedance of the interlayer 217 is higher than that of the upper layer 216 and that of the lower layer 218. Similarly, in the acoustic mirror 220, the impedance of the interlayer is higher than that of the upper layer and that of the lower layer.

In the bulk acoustic wave filter 211, by laminating the acoustic mirrors 220 and 219 on and under the piezoelectric resonator part, respectively, vibrations propagated from the piezoelectric resonator are reflected to the side of the piezoelectric resonator. Accordingly, the piezoelectric resonator can be mechanically held using the substrate 212 without affecting the resonance characteristics of the piezoelectric resonator part.

On the other hand, Patent Document 2 discloses a composite material vibrator in which holding components are connected to a piezoelectric element serving as a vibrating component with reflective layers each having an acoustic impedance lower than that of the piezoelectric element therebetween. In this vibrator, the acoustic impedance $Z_2$ of the reflective layers is lower than the acoustic impedance $Z_1$ of the piezoelectric element, and is lower than the acoustic impedance $Z_3$ of the holding components. Vibrations propagated from the piezoelectric element to the reflective layers are reflected at the interfaces between each of the reflective layers and the corresponding holding component. Therefore, it is believed that the piezoelectric element can be supported without requiring a large vibration damping region. According to the patent document, the reflective layers are composed of, for example, an epoxy resin.

Patent Document 1: Japanese Unexamined Patent Application Publication No. 10-270979
Patent Document 2: Japanese Unexamined Patent Application Publication No. 2002-164764

Disclosure of Invention

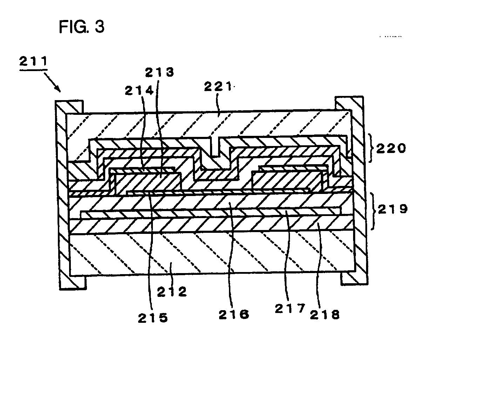

In the bulk acoustic wave filter 211 shown in Fig. 3, the acoustic mirrors 219 and 220 are formed so that vibrations propagated from the side of the piezoelectric resonator are reflected. However, each of the acoustic mirrors 219 and 220 includes the upper layer, the lower layer, and the interlayer laminated therebetween, and the impedance of the interlayer is higher than that of the upper layer and that of the lower layer. Therefore, a large number of material layers must be laminated to form the acoustic mirrors 219 and 220. Thus, although the formation of a cavity can be omitted, a large number of material layers must be laminated in the bulk acoustic wave filter 211. Therefore, it is difficult to reduce the size, in particular, the thickness of the acoustic wave filter. The production process is also complex.

Furthermore, in the bulk acoustic wave filter 211, lateral vibrations of the piezoelectric resonator are propagated, but the vibrations alternately propagated are damped in the lateral parts of the piezoelectric resonator. Accordingly, since the lateral parts of the piezoelectric resonator are fixed, this holding structure degrades the resonance characteristics of the piezoelectric resonator.

In the composite material vibrator described in Patent Document 2, as described above, holding components are connected to a piezoelectric element with reflective layers each having a relatively low acoustic impedance $Z_2$ therebetween. Therefore, it has been believed that the piezoelectric element can be supported by the holding components without affecting the characteristics of the piezoelectric element.

However, when the reflective layers are formed using an epoxy resin, the piezoelectric element cannot necessarily be supported mechanically without suppressing a decrease in electrical characteristics of the piezoelectric element. In other words, even when the holding components are connected to the piezoelectric element with the reflective layers therebetween, it may be difficult to obtain satisfactory electrical characteristics.

An object of the present invention is to eliminate the problems of the above known arts and to provide a composite material vibrator that has a relatively simple structure, that can be supported without hardly affecting the vibration characteristics of the vibrating component, that can be easily reduced in size, and that has excellent electrical characteristics.

In order to achieve the above object, a composite material vibrator of the present invention includes a vibrating component that is composed of a material having a first acoustic impedance $Z_1$ and that serves as a vibration source; a reflective layer that is composed of a cured product of a resin composition containing at least a curable resin curable by heat, a curing agent, and a silicone compound, the cured product having a second acoustic impedance $Z_2$ lower than the first acoustic impedance $Z_1$ and that is connected to the vibrating component; and a holding component that is composed of a material having a third acoustic impedance $Z_3$ higher than the second acoustic impedance $Z_2$ and that is connected to surfaces of the reflective layer, the surface being opposite to the surface connected to the vibrating component, wherein vibration propagated from the vibrating component to the reflective layer is reflected at the interface between the reflective layer and the holding component.

According to a specific aspect of the composite material vibrator of the present invention, the curable resin is an epoxy resin.

According to another specific aspect of the composite material vibrator of the present invention, the silicone compound is contained in the resin composition in an amount of 6 to 60 percent by weight.

According to another specific aspect of the composite material vibrator of the present invention, the silicone compound is a silicone rubber powder coated with a polyorganosilsesquioxane cured product.

In the composite material vibrator of the present invention, preferably, the sound velocity in the reflective layer at 5 MHz is 2,600 m/s or less and the damping coefficient of the reflective layer at 5 MHz is 3.5 dB/mm or less.

In a method for producing a composite material vibrator according to the present invention, a method for obtaining the above composite material vibrator of the present invention includes the steps of preparing the vibrating component and the holding components; preparing an uncured resin composition containing at least a curable resin curable by heat, a curing agent, and a silicone compound; laminating the vibrating component and the holding component with the uncured resin composition; and curing the uncured resin composition to form the reflective layer connected to the vibrating component and the holding component.

According to another specific aspect of the method for producing a composite material vibrator according to the present invention, the production method includes the steps of preparing the vibrating component and the holding component; preparing a resin sheet containing at least a thermosetting resin, a curing agent, and a silicone compound; disposing the resin sheet between the vibrating component and the holding component; and curing the resin sheet to form the reflective layer connected to the vibrating component and the holding component.

In the production method of the present invention, the curing of the resin composition is preferably performed by heating.

According to the composite material vibrator of the present invention, the reflective layer can be formed by merely curing a resin and a plurality of material layers need not be laminated. Consequently, the production process can be simplified. Since the resin used in the reflective layer also has adhesiveness, the reduction in thickness, the reduction in size, and the reduction in cost of the composite material vibrator can be achieved. Furthermore, since the reflective layer of the composite material vibrator of the present invention have a low sound velocity and a low damping, electrical characteristics of the composite material vibrator can be improved.

Brief Description of the Drawings

[Fig. 1] Fig. 1 is an exploded perspective view of a composite material vibrator of the present invention.
[Fig. 2] Fig. 2 is a perspective view showing the appearance of the composite material vibrator of the present invention.
[Fig. 3] Fig. 3 is a longitudinal cross-sectional view showing a bulk acoustic wave filter, which is a known composite material vibrator.

Reference Numerals

| | |
|---|---|
| 1 | composite material vibrator |
| 2 | piezoelectric resonator |
| 3, 4 | reflective layer |
| 5, 6 | holding component |
| 11 | excitation electrode |
| 12, 13 | capacitor electrode |
| 14, 15 | outer electrode |

Best Mode for Carrying Out the Invention

A composite material vibrator of the present invention will now be described.

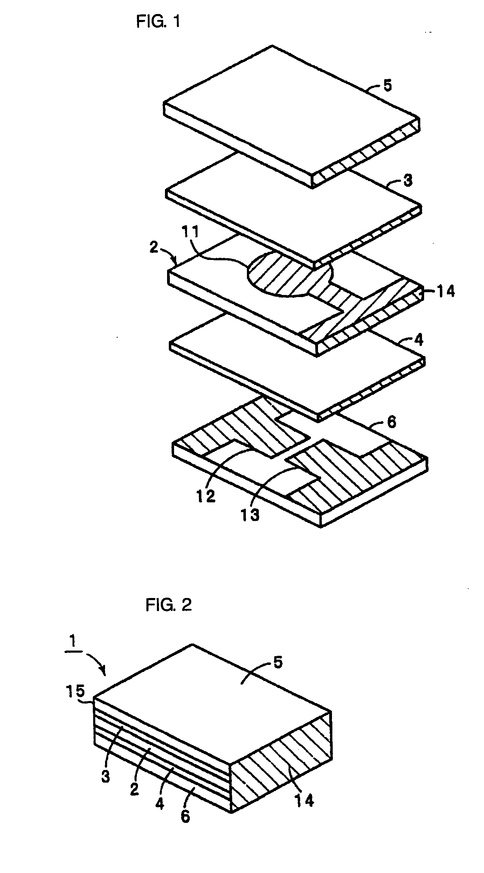

Fig. 1 is an exploded perspective view of a composite material vibrator according to a first embodiment of the present invention, and Fig. 2 is a perspective view showing the appearance thereof.

In a composite material vibrator 1 of this embodiment, a piezoelectric resonator 2 is used as a vibrating component. The piezoelectric resonator 2 is composed of a rectangular lead zirconate titanate piezoelectric ceramic plate. This ceramic plate is subjected to a polarization treatment in the thickness direction. An excitation electrode 11 is provided at the center of the upper surface of the ceramic plate. Although not shown in Fig. 1, another excitation electrode is provided at the center of the lower surface of the ceramic plate. The excitation electrode 11 and the other excitation electrode provided on the lower surface extend to end faces of the ceramic plate and are electrically connected to outer electrodes 14 and 15, respectively.

The piezoelectric resonator 2 is excited in the thickness-shear vibration mode by applying an alternating voltage between the excitation electrode 11 and the other excitation electrode provided on the lower surface. The ceramic plate has an acoustic impedance $Z_1$ of $18.8 \times 10^6$ N·s·m$^{-3}$.

A first reflective layer 3 and a second reflective layer 4 are laminated on the upper surface and the lower surface of the piezoelectric resonator 2, respectively. A first holding component 5 and a second holding component 6 are laminated on the outer surfaces of the reflective layers 3 and 4, respectively, that is, on the surfaces opposite to the surfaces on which the piezoelectric resonator 2 is connected. The reflective layers 3 and 4 are composed of a material that can be adhered by drying, heating, chemical reaction, or the like.

More specifically, in an example of this embodiment, the reflective layers 3 and 4 are composed of a material prepared by curing a resin composition containing at least a thermosetting resin, a curing agent, and a silicone compound, and have an acoustic impedance $Z_2$ of $3.1 \times 10^6$ N·s·m$^{-3}$ or less. Furthermore, the sound velocity in the reflective layers 3 and 4 at 5 MHz is 2,600 m/s or less, and the damping coefficient of the reflective layers 3 and 4 at 5 MHz is 3.5 dB/mm or less. Thereby, a composite material vibrator having excellent electrical characteristics can be obtained.

In this embodiment, each of the holding components 5 and 6 is composed of a rectangular ceramic plate, and has an acoustic impedance $Z_3$ of $18.8 \times 10^6$ N·s·m$^{-3}$. A pair of capacitor electrodes 12 and 13 is provided on the upper surface of the lower holding component 6. Other capacitor electrodes (not shown in the figure) are provided at the center of the lower surface of the holding component 6 so as to face the capacitor electrodes 12 and 13 with the holding component 6 disposed therebetween. The capacitor electrodes 12 and 13 and the other capacitor electrodes provided on the lower surface form a capacitor on the holding component 6.

The outer electrode 14 shown in Fig. 2 is provided on an end face of the laminate prepared by laminating the components shown in Fig. 1. In addition, the outer electrode 15 is provided on the other end face of the laminate. The outer electrodes 14 and 15 are electrically connected to the excitation electrode 11 of the piezoelectric resonator 2 and the other excitation electrode disposed on the lower surface, respectively.

The outer electrodes 14 and 15 are also electrically connected to the capacitor electrodes 13 and 12, respectively. Thus, by electrically connecting the outer electrodes 14 and 15 to the capacitor electrodes provided on the lower surface of the holding component 6 and the outside, the composite material vibrator 1 operates as a three-terminal piezoelectric oscillator with a built-in capacitor.

In the composite material vibrator 1 of this embodiment, the first and second reflective layers 3 and 4 are connected to the upper surface and the lower surface of the piezoelectric resonator 2 serving as a vibrating component, respectively. In addition, the holding components 5 and 6 are connected to the surfaces of the reflective layers 3 and 4, respectively, the surfaces being opposite to the surfaces on which the piezoelectric resonator 2 is connected. Therefore, a cavity for not interfering with the vibration of the piezoelectric resonator 2 is not provided. Thus, since such a cavity need not be formed, the reduction in thickness, the reduction in size, and the reduction in cost can be achieved.

The curable resin used in the reflective layers of the present invention is not particularly limited as long as the resin is cured by heating. The form of the curable resin at room temperature is also not particularly limited and the curable resin may be a liquid or a solid at room temperature. Examples of the thermosetting resin include epoxy resins, urethane resins, vinyl ester resins, phenolic resins, urea resins, melamine resins, unsaturated polyester resins, diallyl phthalate resins, and polyimide resins.

An epoxy resin is preferably used as the thermosetting resin. Thereby, excellent adhesive force and excellent reliability can be achieved. Examples of the epoxy resin include bisphenol epoxy resins, phenol novolak epoxy resins, cresol novolak epoxy resins, ortho-cresol novolak epoxy resins, alicyclic epoxy resins, biphenyl epoxy resins, aralkyl epoxy resins, halogenated epoxy resins, triphenolmethane epoxy resins, naphthalene novolak epoxy resins, aromatic amine epoxy resins, phenol-based multifunctional epoxy resins, and dicyclopentadiene phenol epoxy resins.

These epoxy resins may be used alone or in combinations of two or more resins.

The curing agent used in the reflective layers of the present invention is an adequate compound that cures the curable resin. Examples of the curing agent used for thermosetting resins include amines, aliphatic polyamines, modified aliphatic polyamines, acid anhydrides, phenol, imidazoles, epoxy-imidazole adducts, amine adducts, and diaminodiphenyl sulfone. These curing agents may be used alone or as a mixture of two or more compounds.

In the present invention, examples of the silicone compound used in the reflective layers include polydimethylsiloxane, polymethylphenylsiloxane, polydiphenylsiloxane, and polymethylsilsesquioxane. Resinoids, i.e., silicone resins may also be used as the silicone compound. The silicone compounds may be in the form of a liquid or in the form of a power. Powdery compounds are preferable because of their high heat resistance. These silicone compounds may be used alone or in combinations of two or more compounds.

The silicone compound used in the reflective layers of the present invention is preferably contained in an amount of 6 to 60 percent by weight in the resin composition constituting the reflective layers. When the content is less than 6 percent by weight, electrical characteristics of the composite material vibrator tend to be degraded because the sound velocity in the resin composition is not decreased. On the other hand, when the content exceeds 60 percent by weight, the viscosity of the resin composition is increased. As a result, the flowability of the resin composition is decreased during the formation of the reflective layers of the composite material vibrator. Thus, it may take a long time to form a desired shape.

In the present invention, a silicone rubber powder coated with a polyorganosilsesquioxane cured product is preferably used as the silicone compound contained in the reflective layers. The polyorganosilsesquioxane cured product is a substance prepared by curing a polyorganosilsesquioxane by polymerization reaction. The polyorganosilsesquioxane cured product is represented by a general formula $RSiO_{3/2}$. In the formula, R represents at least one monovalent hydrocarbon group having 1 to 20 carbon atoms, the hydrocarbon group being selected from alkyl groups such as methyl, ethyl, propyl, butyl, pentyl, hexyl, heptyl, octyl, nonyl, decyl, dodecyl, tetradecyl, hexadecyl, octadecyl, and eicosyl groups; aryl groups such as phenyl and tolyl groups; alkenyl groups such as vinyl and allyl groups; aralkyl groups such as β-phenylethyl and β-phenylpropyl groups; monovalent halogenated hydrocarbon groups such as chloromethyl and 3,3,3-trifluoropropyl group; and hydrocarbon groups having reactivity, such as epoxy, amino, mercapto, acryloxy, and methacryloxy groups. The particle size of the silicone rubber powder coated with a polyorganosilsesquioxane cured product is not particularly limited but, for example, a powder having an average particle size of about 0.1 to 100 μm is used.

When the silicone rubber powder coated with a polyorganosilsesquioxane cured product is added to the resin composition for the reflective layers, the amount added is preferably 6 to 60 percent by weight of the total of the resin composition. When the amount is less than 6 percent by weight, the effect by the addition of the silicone rubber powder, i.e., the effect of satisfactorily decreasing the sound velocity may be difficult to be achieved. On the other hand, when the amount exceeds 60 percent by weight, the viscosity of the resin composition is increased. As a result, the flowability of the resin composition is decreased during the formation of the reflective layers of the composite material vibrator. Thus, it may take a long time to form a desired shape.

In addition to the above materials constituting the reflective layers of the present invention, in order to impart the curability, the adhesiveness, the thixotropic property, or the like according to the intended use, inorganic fillers such as fused silica, crushed silica, silica fine particles, talc, and glass; inorganic fillers prepared by performing a surface treatment such as a hydrophobic treatment or a hydrophilic treatment on the above inorganic fillers; life stabilizers; coupling agents such as alkoxysilanes; leveling agents; diluents; flame retardants; lubricants; rheology-controlling agents; antisettling agents; adhesiveness imparting agents; pigments; dispersing agents; antifoaming agents; or the like may be added.

In the production of the composite material vibrator according to the present invention, when the above-described vibrating component and the holding component are connected with the reflective layer, a method of applying a resin composition for forming the reflective layer on at least one of the vibrating component and the holding component, bonding the vibrating component and the holding component with the resin composition provided therebetween, and curing the resin composition can be employed. The resin composition constituting the reflective layers may be provided in the form of a semi-cured adhesive sheet. In such a case, a resin composition containing an appropriate sheet-forming material in addition to the curable resin, the curing agent, and the silicone compound is suitably used. When the resin composition prepared in the form of the semi-cured adhesive sheet is used, the semi-cured adhesive sheet is disposed between the vibrating component and the holding component and the resin composition provided in the form of the adhesive sheet is cured while these three components are in close contact with each other.

The method for curing the resin composition is not particularly limited. When the resin composition contains a curing agent that is activated by heat, the resin composition can be cured by heating. Thus, a curable resin such as an epoxy resin may be cured.

Experimental examples of the present invention will now be described.

(1) Experimental Example 1

(a) Preparation of resin cured products

First, as starting materials for resin compositions used for the reflective layers, thermosetting resins 1 and 2, curing agent 1, and a silicone compound were prepared. In this experiment, thermosetting resin 1 was a p-aminophenol epoxy resin (epoxy equivalent = 97 g/eq), thermosetting resin 2 was a tetraglycidylaminodiphenylmethane epoxy resin (epoxy equivalent = 120 g/eq), curing agent 1 was 2-phenyl-4-methyl-5-hydroxymethyl imidazole, and the silicone compound used was a spherical silicone resin powder having an average particle size of 2 $\mu$m.

Next, these starting materials were weighed so as to prepare resin compositions having the compositions shown in Table 1. Mixing and vacuum mixing were performed with a planetary mixer to prepare resin compositions of Sample Nos. 1 to 5 shown in Table 1. Subsequently, each of the resin compositions was supplied in an ethylene fluoride resin mold and vacuum deaeration was performed. The resin compositions were then left to stand in an oven at 150°C for one hour to prepare target resin cured products.

[Table 1]

| | | | | | * |
|---|---|---|---|---|---|
| Sample No. | 1 | 2 | 3 | 4 | 5 |
| Thermosetting resin 1 (g) | 65 | 65 | 65 | 65 | 65 |
| Thermosetting resin 2 (g) | 35 | 35 | 35 | 35 | 35 |
| Curing agent 1 (g) | 4 | 4 | 4 | 4 | 4 |
| Silicone compound (g) <Content in resin composition (wt%)> | 20 <16> | 45 <30> | 60 <37> | 75 <42> | 0 <0> |
| Sound velocity (m/s) | 2502 | 2343 | 2296 | 2221 | 2681 |
| Density ($10^3 \cdot$Kg/m$^3$) | 1.25 | 1.26 | 1.26 | 1.27 | 1.25 |
| Damping coefficient (dB/mm) | 2.68 | 2.09 | 2.17 | 1.98 | 3.60 |
| Acoustic impedance ($10^6$N·s·m$^{-3}$) | 3.1 | 3.0 | 2.9 | 2.8 | 3.4 |
| Electrical characteristics | Good | Good | Good | Good | Not good |

(b) Preparation of composite material vibrators

As shown in Figs. 1 and 2, each of the uncured resin compositions of Sample Nos. 1 to 5 was applied on a piezoelectric resonator 2 composed of a ceramic having an acoustic impedance of $18.8 \times 10^6$ N·s·m$^{-3}$. The resulting piezoelectric resonator 2 was laminated with holding components 5 and 6 each composed of a ceramic having an acoustic impedance of $18.8 \times 10^6$ N·s·m$^{-3}$ and the laminate was left to stand in an oven at 150°C for one hour to cure the resin composition. When the resin composition was applied, the application thickness was adjusted such that the thickness of the resin cured product (reflective layer) after curing corresponded to a quarter ($\lambda/4$) of the oscillation wavelength ($\lambda$) of the piezoelectric resonator. Subsequently, outer electrodes 14 and 15 shown in Figs. 1 and 2 were formed to prepare target composite material vibrators.

(c) Characteristic evaluation of resin cured products

The sound velocity, the damping coefficient, the density, and the acoustic impedance of the resin cured products prepared in section (a) were evaluated.

Regarding the sound velocity (m/s), a value (of longitudinal waves) at 5 MHz was calculated from equation 1 with an ultrasonic viscoelasticity measuring instrument (RAM-10000, manufactured by RITEC).

$$\texttt{Equation 1: Sound velocity = L/t}$$

In equation 1, L represents the thickness (m) of the resin cured product and t represents a time (s) required for the propagation of ultrasonic waves.

Regarding the damping coefficient (dB/mm), a value (of longitudinal waves) at 5 MHz was calculated from equation 2 with the ultrasonic viscoelasticity measuring instrument.

$$\texttt{Equation 2: Damping coefficient = \{ln[(A_0^2 -}$$

$$\texttt{A^2)/A_0 B]\}/(17.372 \times L \times 10^3)}$$

In equation 2, $A_0$ represents an amplitude (m) of reflected waves at the bottom surface of a cushioning material of the measuring instrument, A represents an amplitude (m) of reflected waves at the interface between the cushioning material and the resin cured product, B represents an amplitude (m) of reflected waves at the bottom surface of the resin cured product, and L represents the thickness (m) of the resin cured product.

The density ($10^3 \cdot kg/m^3$) was calculated from the weight (kg) and the volume ($m^3$) of the resin cured product. Regarding the acoustic impedance ($10^6$ N·s·m$^{-3}$), a value (of longitudinal waves) at 5 MHz was calculated from equation 3 using the measured values of the density and the sound velocity.

Equation 3: Acoustic impedance = density $\times$ sound velocity (d) Evaluation of electrical characteristics of composite material vibrators

Electrical characteristics of the composite material vibrators prepared in section (b) were measured. As the electrical characteristics, the maximum value of the phase was measured. When the maximum value of the phase is large, the electrical characteristics are excellent. When the maximum value of the phase was 78 degrees or more, the sample was evaluated as "Good" in Table 1. When the maximum value of the phase was less than 78 degrees, the sample was evaluated as "Not good" in Table 1.

Table 1 shows the evaluation results described in sections (c) and (d). In Table 1, the sample marked with symbol * is out of the range of the present invention and other samples are within the range of the present invention.

As is apparent from Table 1, Sample Nos. 1 to 4, which contained the silicone compound showed low sound velocities, low damping coefficients, and satisfactory electrical characteristics. In contrast, in Sample No. 5, which did not contain the silicone compound, both the sound velocity and the damping coefficient were increased and the electrical characteristics were also degraded, as compared with those of Sample Nos. 1 to 4.

(2) Experimental Example 2

(e) Preparation of resin cured products and composite material vibrators

First, as starting materials of resin compositions used for the reflective layers, thermosetting resins 1 and 2 and the silicone compound, which were the same as those used in Example 1, were prepared. An epoxy-imidazole adduct serving as curing agent 2 and a carboxyl-group-terminated acrylonitrile-butadiene copolymer were prepared.

Next, these starting materials were weighed so as to prepare resin compositions having the compositions shown in Table 2. Mixing and vacuum mixing were performed with a planetary mixer to prepare resin compositions of Sample Nos. 6 to 11 shown in Table 2. Subsequently, target resin cured products were prepared as in section (a).

[Table 2]

| | 6 | 7 | 8 | 9 | 10 | 11 * |
|---|---|---|---|---|---|---|
| Sample No. | 6 | 7 | 8 | 9 | 10 | 11 |
| Thermosetting resin 1 (g) | 100 | 100 | 100 | 100 | 100 | 100 |
| Thermosetting resin 2 (g) | 0 | 0 | 0 | 0 | 0 | 0 |
| Curing agent 2 (g) | 20 | 20 | 20 | 20 | 20 | 20 |
| Silicone compound (g) <Content in resin composition (wt%)> | 7 <6> | 14 <10> | 50 <29> | 70 <37> | 87 <42> | 0 <0> |
| Carboxyl-group-terminated acrylonitrile-butadiene copolymer (g) <Content in resin composition (wt%)> | 0 <0> | 0 <0> | 0 <0> | 0 <0> | 0 <0> | 7 <6> |
| Sound velocity (m/s) | 2569 | 2497 | 2202 | 2164 | 2011 | 2638 |
| Density ($10^3 \cdot Kg/m^3$) | 1.21 | 1.21 | 1.22 | 1.22 | 1.22 | 1.22 |
| Damping coefficient (dB/mm) coefficient | 3.10 | 2.86 | 2.41 | 2.32 | 2.10 | 3.63 |
| Acoustic impedance ($10^6 N \cdot s \cdot m^{-3}$) | 3.1 | 3.0 | 2.7 | 2.6 | 2.5 | 3.2 |
| Electrical characteristics | Good | Good | Good | Good | Good | Not good |

Target composite material vibrators were also prepared as in section (b) using uncured resin compositions of Sample Nos. 6 to 11 shown in Table 2.

(f) Evaluation of characteristics of resin cured products and electrical characteristics of composite material vibrators

The sound velocity, the damping coefficient, the density, and the acoustic impedance of the resin cured products prepared in section (e) were evaluated as in section (c).

The electrical characteristics of the composite material vibrators prepared in section (e) were also evaluated as in section (d).

Table 2 shows the evaluation results of the resin cured products and the composite material vibrators. In Table 2, the sample marked with symbol * is out of the range of the present invention and other samples are within the range of the present invention.

As is apparent from Table 2, Sample Nos. 6 to 10, which contained the silicone compound showed low sound velocities, low damping coefficients, and satisfactory electrical characteristics. In contrast, in Sample No. 11, which did not contain the silicone compound but contained the carboxyl-group-terminated acrylonitrile-butadiene copolymer, both the sound velocity and the damping coefficient were increased and the electrical characteristics were also degraded, as compared with those of Sample Nos. 6 to 10.

(3) Experimental Example 3

(g) Preparation of resin cured products and composite material vibrators

First, as starting materials of resin compositions used for the reflective layers, thermosetting resins 1 and 2 and the silicone compound, which were the same as those used in Example 2 and polymethyl methacrylate were prepared. As curing agent 3, polyoxypropylenediamine (average molecular weight: 230, active hydrogen equivalent = 60 g/eq) was prepared.

Next, these starting materials were weighed so as to prepare resin compositions having the compositions shown in Table 3. Mixing and vacuum mixing were performed with a planetary mixer to prepare resin compositions of Sample Nos. 12 to 14 shown in Table 3. Subsequently, target resin cured products were prepared as in section (a).

[Table 3]

| | | | * |
|---|---|---|---|
| Sample No. | 12 | 13 | 14 |
| Thermosetting resin 1 (g) | 100 | 100 | 100 |
| Thermosetting resin 2 (g) | 0 | 0 | 0 |
| Curing agent 3 (g) | 58 | 20 | 20 |
| Silicone compound (g) <Content in resin composition (wt%)> | 237 <60> | 164 <51> | 0 <0> |
| Polymethyl methacrylate (g) <Content in resin composition (wt%)> | 0 <0> | 0 <0> | 164 <51> |
| Sound velocity (m/s) | 2075 | 2264 | 2000 |
| Density ($10^3 \cdot Kg/m^3$) | 1.22 | 1.21 | 1.18 |
| Damping coefficient (dB/mm) | 3.30 | 3.50 | 4.50 |
| Acoustic impedance ($10^6 N \cdot s \cdot m^{-3}$) | 2.5 | 2.7 | 2.4 |
| Electrical characteristics | Good | Good | Not good |

Target composite material vibrators were also prepared as in section (b) using uncured resin compositions of Sample Nos. 12 to 14 shown in Table 3.

(h) Evaluation of characteristics of resin cured products and electrical characteristics of composite material vibrators

The sound velocity, the damping coefficient, the density, and the acoustic impedance of the resin cured products prepared in section (g) were evaluated as in section (c).
The electrical characteristics of the composite material vibrators prepared in section (g) were also evaluated as in section (d).
Table 3 shows the evaluation results of the resin cured products and the composite material vibrators. In Table 3, the sample marked with symbol * is out of the range of the present invention and other samples are within the range of the present invention.
As is apparent from Table 3, Sample Nos. 12 and 13, which contained the silicone compound showed low sound velocities, low damping coefficients, and satisfactory electrical characteristics. In contrast, in Sample No. 13, which did not contain the silicone compound but contained polymethyl methacrylate, both the sound velocity and the damping coefficient were increased and the electrical characteristics were also degraded, as compared with those of Sample Nos. 11 and 12.

(4) Experimental Example 4

(k) Preparation of resin cured products and composite material vibrators

First, as starting materials of resin compositions used for the reflective layers, thermosetting resin 1 and curing agent 1, which were the same as those used in Example 1, were prepared. As a silicone compound, a silicone rubber powder coated with a polymethylsilsesquioxane cured product, the power having a Japanese Industrial Standard (JIS)-A hardness of 75 (JIS-K-6301) was prepared.
Subsequently, these starting materials were weighed so as to prepare resin compositions of Sample Nos. 17 to 20 having the compositions shown in Table 5. Mixing and vacuum mixing were performed with a planetary mixer to prepare resin compositions of Sample Nos. 17 to 20 shown in Table 4. Subsequently, target resin cured products were prepared as in section (a).
Target composite material vibrators were also prepared as in section (b) using uncured resin compositions of Sample Nos. 15 to 18 shown in Table. 4.

(1) Evaluation of characteristics of resin cured products and electrical characteristics of composite material vibrators

The sound velocity, the damping coefficient, the density, and the acoustic impedance of the resin cured products prepared in section (k) were evaluated as in section (c).

The electrical characteristics of the composite material vibrators prepared in section (k) were also evaluated as in section (d).

Table 4 shows the evaluation results of the resin cured products and the composite material vibrators. In Table 4, the sample marked with symbol * is out of the range of the present invention and other samples are within the range of the present invention.

[Table 4]

| | | | | * |
|---|---|---|---|---|
| Sample No. | 15 | 16 | 17 | 18 |
| Thermosetting resin 1 (g) | 100 | 100 | 100 | 100 |
| Curing agent 1 (g) | 4 | 4 | 4 | 4 |
| Silicone rubber powder coated with polyorganosilsesquioxane cured product <Content in resin composition (wt%)> | 47 <31> | 58 <36> | 72 <41> | 0 <0> |
| Sound velocity (m/s) | 1900 | 1800 | 1750 | 2650 |
| Density ($\times 10^3 Kg/m^3$) | 1.18 | 1.15 | 1.13 | 1.28 |
| Damping coefficient (dB/mm) | 3.00 | 3.10 | 3.15 | 2.35 |
| Acoustic impedance ($\times 10^6 N \cdot s \cdot m^{-3}$) | 2.2 | 2.1 | 2.0 | 3.4 |
| Electrical characteristics | Good | Good | Good | Not good |

As is apparent from Table 4, Sample Nos. 15, 16, and 17, which contained the silicone compound showed low sound velocities and satisfactory electrical characteristics. In contrast, in Sample No. 18, which did not contain the silicone compound, the sound velocity was increased and the electrical characteristics were also degraded, as compared with those of Sample Nos. 15, 16, and 17.

(5) Experimental Example 5

(m) Preparation of acoustic reflection resin sheet

A bisphenol-A epoxy resin (epoxy equivalent = 190 g/eq) and o-cresol novolak epoxy resin (epoxy equivalent = 215 g/eq) that serve as thermosetting resins, phenol novolak (OH equivalent = 105 g/eq) serving as a curing agent, a polyvinyl butyral resin (weight-average molecular weight: 50,000) serving as a thermoplastic resin, a silicone resin powder (polymethylsilsesquioxane, average particle size: 2 $\mu$m) serving as a silicone compound, and methyl ethyl ketone serving as a solvent were prepared. These compounds were appropriately weighed as shown in Table 5, and were then mixed with a planetary mixer for one hour to prepare a slurry. The o-cresol novolak epoxy resin and the polyvinyl butyral resin were dissolved in methyl ethyl ketone serving as a solvent in advance and used. The slurry was subjected to vacuum deaeration. Subsequently, a sheet forming was performed by applying the slurry on a carrier film (polyethylene terephthalate (PET), thickness: 50 $\mu$m) at 50°C so that the surface coated with the silicone was disposed at the upper side. Thus, an acoustic reflection resin sheet was prepared. The sheet forming was performed using a doctor blade with a clearance of 200 $\mu$m and a winding speed of 15 cm/min.

(n) Preparation of composite material vibrator and evaluation of electrical characteristics thereof

As shown in Figs. 1 and 2, a piezoelectric resonator 2 and reflective layers 3 and 4 each composed of the acoustic reflection resin sheet removed from the carrier film were laminated with holding components 5 and 6, and the resulting laminate was cured at 150°C for one hour while being pressed. Subsequently, outer electrodes 14 and 15 were formed to prepare a composite material vibrator. Each of the acoustic reflection resin sheets was adjusted such that the thickness of the resin sheet after curing was about $\lambda$/4 wherein $\lambda$ represents an oscillation wavelength of the piezoelectric resonator. As the electrical characteristics of the resulting composite material vibrator, the maximum value of the phase was measured. When the maximum value of the phase is large, the electrical characteristics are excellent. When the maximum value of the phase was 78 degrees or more, the sample was evaluated as "Good". When the maximum value of the phase was 78 degrees or less, the sample was evaluated as "Not good".

(o) Bleeding

The acoustic reflection resin sheet prepared in section (m) was aligned between glass substrates and laminated. The laminate was then cured with a special fixture under pressure at 150°C for one hour. Subsequently, the width of bleeding from the glass substrates was measured with a length measuring device to evaluate the bleeding. When the width of the bleeding was 3 mm or less, the sample was evaluated as "Good". When the width of the bleeding was 3 mm or more, the sample was evaluated as "Not good".

(p) Adhesiveness

The adhesiveness of the composite material vibrator prepared in section (n) was evaluated by a die shear test. Regarding the adhesiveness, when the adhesive strength was 5N, the sample was evaluated as "Good". When the adhesive strength was 5N or less, the sample was evaluated as "Not good".

(q) Preparation of resin sheet

As Comparative Example 1, a bisphenol-A epoxy resin (epoxy equivalent = 190 g/eq) and o-cresol novolak epoxy resin (epoxy equivalent = 215 g/eq) that serve as thermosetting resins, phenol novolak (OH equivalent = 105 g/eq) serving as a curing agent, a polyvinyl butyral resin (weight-average molecular weight: 50,000) serving as a thermoplastic resin, and methyl ethyl ketone serving as a solvent were mixed with a planetary mixer for one hour to prepare a slurry. The o-cresol novolak epoxy resin and the polyvinyl butyral resin were dissolved in methyl ethyl ketone serving as a solvent in advance and used. The resulting slurry was subjected to vacuum deaeration. Subsequently, a sheet forming was performed by applying the slurry on a carrier film (PET, thickness: 50 $\mu$m) at 50°C so that the surface coated with the silicone was disposed at the upper side. Thus, a reflection resin sheet was prepared. The sheet forming was performed using a doctor blade with a clearance of 200 $\mu$m and a winding speed of 15 cm/min.

(r) Preparation of composite material vibrator and evaluation of electrical characteristics thereof

As shown in Figs. 1 and 2, a piezoelectric resonator 2 and reflective layers 3 and 4 composed of the resin sheet removed from the carrier film were laminated with holding components 5 and 6, and the resulting laminate was cured at 150°C for one hour while being pressed. Subsequently, outer electrodes 14 and 15 were formed to prepare a composite material vibrator. The acoustic reflection resin sheet was adjusted such that the thickness of the resin sheet after curing was about $\lambda/4$ wherein $\lambda$ represents an oscillation wavelength of the piezoelectric resonator. As the electrical characteristics of the resulting composite material vibrator, the maximum value of the phase was measured. When the maximum value of the phase is large, the electrical characteristics are excellent. When the maximum value of the phase was 78 degrees or more, the sample was evaluated as "Good". When the maximum value of the phase was 78 degrees or less, the sample was evaluated as "Not good".

(s) Preparation of liquid epoxy resin composition

As Comparative Example 2, a p-aminophenol epoxy resin (epoxy equivalent = 97 g/eq), an epoxy-imidazole adduct serving as a curing agent, fine silica particles (hydrophobic-treated silica, primary particle size: 16 nm), and a silicone resin powder (polymethylsilsesquioxane, average particle size: 2 $\mu$m) serving as a silicone compound were mixed with a planetary mixer for one hour to prepare a liquid epoxy resin composition.

(t) Preparation of composite material vibrator and evaluation of electrical characteristics thereof

As shown in Figs. 1 and 2, the liquid epoxy resin composition prepared in section (1) was applied on a piezoelectric resonator 2 with a dispenser, and a holding component is then laminated thereon. Furthermore, the liquid epoxy resin composition prepared in section (1) was applied on a holding component 6 with the dispenser and the holding component 6 was then laminated on the piezoelectric resonator 2. Thus, the liquid epoxy resin composition was applied between the piezoelectric resonator 2 and the holding component 5 and between the piezoelectric resonator 2 and the holding component 6. The laminate was then cured at 150°C for one hour while being pressed. Subsequently, a composite material vibrator was prepared as in the case of the resin and evaluated.

Table 5 shows the evaluation results. In Table 5, the samples marked with symbol * are out of the range of the present invention and the other sample is within the range of the present invention.

[Table 5]

|  |  |  | * | * |
|---|---|---|---|---|
| Sample No. |  | 19 | 20 | 21 |
| Thermosetting resin | Blsphenol-A epoxy resin | 9.0 | 9.0 | - |
|  | o-Cresol novolak epoxy resin | 1.5 | 1.5 | - |
|  | p-Aminophenol epoxy resin | - | - | 100 |
| Curing agent | Phenol novolak | 5.2 | 5.2 | - |
|  | Epoxy-imidazole adduct | - | - | 20 |
| Thermoplastic resin | Polyvinyl butyral resin | 6.0 | 6.0 | - |
| Additive | Silicone compound | 23.5 | - | 60 |
|  | Fine silica particles | - | - | 2 |
| Solvent | Methyl ethyl ketone | 100 | 100 | - |
| Electrical characteristics |  | Good | Not good | Good |
| Bleeding |  | Good | Good | Not good |
| Adhesiveness |  | Good | Good | Good |

Referring to Table 5, Sample No. 19 including the acoustic reflection resin sheet was excellent in electrical characteristics because of the presence of the silicone compound as compared with Sample No. 20, which did not contain the silicone compound. In addition, in view of the bleeding, Sample No. 19 was superior to Sample No. 21, which included the liquid epoxy resin composition. The possible reason for this is as follows. Since the liquid epoxy resin composition had a high flowability, the bleeding significantly occurred. In contrast, since the acoustic reflection resin sheet had a low flowability, the bleeding was suppressed.

**Claims**

1.  A composite material vibrator comprising:

    a vibrating component that is composed of a material having a first acoustic impedance $Z_1$ and that serves as a vibration source;
    a reflective layer that is composed of a cured product of a resin composition containing at least a curable resin curable by heat, a curing agent, and a silicone compound, the cured product having a second acoustic impedance $Z_2$ lower than the first acoustic impedance $Z_1$ and that is connected to the vibrating component; and
    a holding component that is composed of a material having a third acoustic impedance $Z_3$ higher than the second acoustic impedance $Z_2$ and that is connected to surfaces of the reflective layer, the surface being opposite to the surface connected to the vibrating component,
    wherein vibration propagated from the vibrating component to the reflective layer is reflected at the interface between the reflective layer and the holding component.

2.  The composite material vibrator according to claim 1, wherein the curable resin is an epoxy resin.

3.  The composite material vibrator according to claim 1 or 2, wherein the silicone compound is contained in the resin composition in an amount of 6 to 60 percent by weight.

4.  The composite material vibrator according to any one of claims 1 to 3, wherein the silicone compound is a silicone resin powder.

5.  The composite material vibrator according to any one of claims 1 to 3, wherein the silicone compound is a silicone rubber powder coated with a polyorganosilsesquioxane cured product.

6. The composite material vibrator according to any one of claims 1 to 3, wherein the sound velocity in the reflective layer at 5 MHz is 2,600 m/s or less and the damping coefficient of the reflective layer at 5 MHz is 3.5 dB/mm or less.

7. The composite material vibrator according to any one of claims 1 to 6, wherein the vibrating component is a piezoelectric vibrating element.

8. A method for producing the composite material vibrator according to claim 1, comprising the steps of:

    preparing the vibrating component and the holding component;
    preparing an uncured resin composition containing at least a curable resin curable by heat or light, a curing agent, and a silicone compound;
    laminating the vibrating component and the holding component with the uncured resin composition; and
    curing the uncured resin composition to form the reflective layer connected to the vibrating component and the holding component.

9. A method for producing the composite material vibrator according to claim 1, comprising the steps of:

    preparing the vibrating component and the holding components;
    preparing a resin sheet containing at least a curable resin, a curing agent, and a silicone compound;
    disposing the resin sheet between the vibrating component and the holding component; and
    curing the resin sheet to form the reflective layer connected to the vibrating component and the holding component.

10. The method for producing the composite material vibrator according to claim 8 or 9, wherein the curing is performed by heating.

FIG. 1

5

3

11

2

14

4

6

12

13

FIG. 2

1

15

5

3 2

4 6

14

FIG. 3

<table>
<tr><td colspan="2" align="center">**INTERNATIONAL SEARCH REPORT**</td><td colspan="2">International application No.<br>PCT/JP2004/017054</td></tr>
</table>

A. CLASSIFICATION OF SUBJECT MATTER
   Int.Cl$^7$ H03H9/17, H03H9/05, H03H3/02, G10K11/04, H01L41/08, H01L41/22

According to International Patent Classification (IPC) or to both national classification and IPC

B. FIELDS SEARCHED

Minimum documentation searched (classification system followed by classification symbols)
   Int.Cl$^7$ H03H3/007-9/76, G10K11/04, H01L41/08, H01L41/22

Documentation searched other than minimum documentation to the extent that such documents are included in the fields searched
   Jitsuyo Shinan Koho          1922-1996   Toroku Jitsuyo Shinan Koho   1994-2005
   Kokai Jitsuyo Shinan Koho    1971-2005   Jitsuyo Shinan Toroku Koho   1996-2005

Electronic data base consulted during the international search (name of data base and, where practicable, search terms used)
   WPI/L

C. DOCUMENTS CONSIDERED TO BE RELEVANT

| Category* | Citation of document, with indication, where appropriate, of the relevant passages | Relevant to claim No. |
|---|---|---|
| A | JP 2002-164764 A (Murata Mfg. Co., Ltd.),<br>07 June, 2002 (07.06.02),<br>Claims; Par. No. [0024]; all drawings<br>& DE 10158110 A1          & JP 2002-158850 A<br>& JP 2002-223146 A        & CN 1359193 A<br>& KR 2002041314 A         & US 2004/0012306 A1 | 1-10 |
| A | JP 2002-223146 A (Murata Mfg. Co., Ltd.),<br>09 August, 2002 (09.08.02),<br>Claims; Par. No. [0029]; all drawings<br>& DE 10158110 A1          & JP 2002-158850 A<br>& JP 2002-164764 A        & CN 1359193 A<br>& KR 2002041314 A         & US 2004/0012306 A1 | 1-10 |

| ☒ Further documents are listed in the continuation of Box C. | ☐ See patent family annex. |

\*      Special categories of cited documents:
"A"   document defining the general state of the art which is not considered to be of particular relevance
"E"   earlier application or patent but published on or after the international filing date
"L"   document which may throw doubts on priority claim(s) or which is cited to establish the publication date of another citation or other special reason (as specified)
"O"   document referring to an oral disclosure, use, exhibition or other means
"P"   document published prior to the international filing date but later than the priority date claimed

"T"   later document published after the international filing date or priority date and not in conflict with the application but cited to understand the principle or theory underlying the invention
"X"   document of particular relevance; the claimed invention cannot be considered novel or cannot be considered to involve an inventive step when the document is taken alone
"Y"   document of particular relevance; the claimed invention cannot be considered to involve an inventive step when the document is combined with one or more other such documents, such combination being obvious to a person skilled in the art
"&"   document member of the same patent family

| Date of the actual completion of the international search<br>   25 February, 2005 (25.02.05) | Date of mailing of the international search report<br>   15 March, 2005 (15.03.05) |
|---|---|
| Name and mailing address of the ISA/<br>   Japanese Patent Office | Authorized officer |
| Facsimile No. | Telephone No. |

Form PCT/ISA/210 (second sheet) (January 2004)

**INTERNATIONAL SEARCH REPORT**

International application No.

PCT/JP2004/017054

C (Continuation). DOCUMENTS CONSIDERED TO BE RELEVANT

| Category* | Citation of document, with indication, where appropriate, of the relevant passages | Relevant to claim No. |
|---|---|---|
| A | JP 2000-256628 A (Hitachi Chemical Co., Ltd.), 19 September, 2000 (19.09.00), Par. No. [0017] (Family: none) | 1-10 |
| A | JP 8-113698 A (Meidensha Corp.), 07 May, 1996 (07.05.96), Claims (Family: none) | 1-10 |

Form PCT/ISA/210 (continuation of second sheet) (January 2004)